## Europäisches Patentamt

## European Patent Office

## Office européen des brevets

(11) Veröffentlichungsnummer: **0 149 152
B1**

(12) **EUROPÄISCHE PATENTSCHRIFT**

(45) Veröffentlichungstag der Patentschrift:
22.03.89

(21) Anmeldenummer: **84115389.3**

(22) Anmeldetag: **13.12.84**

(51) Int. Cl.⁴: **H 03 G 3/20, H 04 L 27/08**

(54) Schaltungsanordnung für eine digitale Pegelregelung.

(30) Priorität: **19.01.84 DE 3401748**

(43) Veröffentlichungstag der Anmeldung:
**24.07.85 Patentblatt 85/30**

(45) Bekanntmachung des Hinweises auf die Patenterteilung:
**22.03.89 Patentblatt 89/12**

(84) Benannte Vertragsstaaten:
**AT BE CH DE FR GB IT LI NL SE**

(56) Entgegenhaltungen:
**DE-A- 3 206 114
DE-B- 2 553 631
US-A- 3 378 786
US-A- 3 593 176
US-H- 534 016**

**Nachrichtentechnische Zeitschrift, 1964, Heft 10, pp.
521-526**

(73) Patentinhaber: **Siemens Aktiengesellschaft Berlin und
München, Wittelsbacherplatz 2, D-8000 München 2 (DE)**

(72) Erfinder: **Schenk, Heinrich, Dr.-Ing.,
Becker-Gundahl-Strasse 1, D-8000 München 71 (DE)**

**Beschreibung**

Die Erfindung betrifft eine Schaltungsanordnung für eine digitale Pegelregelung mit einem in seiner Verstärkung einstellbaren Regelverstärker, der von einem Regler her für eine stufenweise Veränderung seines Ausgangspegels in vorgegebenen Zeitabständen Stellsignale zugeführt erhält, und mit einem Pegeldiskriminator, der bei einer Abweichung des von dem Regelverstärker als Regelgrösse abgegebenen Pegels von einem Sollpegel ein die Richtung der Regelabweichung anzeigendes Signal als Stellgrösse an den Regler abgibt.

Es ist bereits ein digitaler Leitungsregler für Trägerfrequenz-Weitverkehrssysteme bekannt (Nachrichtentechnische Zeitschrift, 1964, Heft 10, Seiten 521 bis 526). Bei diesem digitalen Leitungsregler erfolgt die Regelung stufenweise mit einer konstanten Regelgeschwindigkeit. Der Leitungsregler weist hierfür einen Pegeldiskriminator auf, der das Vorliegen einer Pegelabweichung und deren Vorzeichen erkennt. Dieser Pegeldiskriminator gibt je nach der Richtung der Regelabweichung digitale Signale als Stellgrössen an ein Stellwerk ab, das auf derartige Signale hin Stellsignale an einen in seiner Verstärkung einstellbaren Regelverstärker für eine stufenweise Veränderung des Leitungspegels abgibt. Das Stellwerk besteht dabei im wesentlichen aus einem reversiblen Binärzähler, dessen Zählerstände durch die von dem Pegeldiskriminator abgegebenen Signale in fest vorgegebenen Zeitabständen, die durch von einem Taktgenerator abgegebene Taktimpulse festgelegt sind, in der einen oder anderen Richtung verändert werden. Aus diesen Zählerständen werden dann die an den Regelverstärker abzugebenden Stellsignale abgeleitet. Da der Binärzähler von dem Taktgenerator her lediglich in einem fest vorgegebenen Zeitabstand Taktsignale für eine Änderung seines Zählerstandes zugeführt erhält, arbeitet der bekannte Leitungsregler mit konstanter, von der Regelabweichung unabhängiger Regelgeschwindigkeit. Eine solche konstante Regelgeschwindigkeit wirkt sich aber zuweilen nachteilig auf das dynamische Verhalten des Leitungsreglers aus.

Darüber hinaus ist eine Schaltungsanordnung zur Pegelregelung eines einstellbaren Verstärkers bekannt (US-A 3 378 786). Bei dieser bekannten Schaltungsanordnung werden bei Abweichungen der Ausgangspegel dieses einstellbaren Verstärkers von einem festgelegten Referenzwert Fehlersignale erzeugt. Nach Massgabe des Betrages dieser Fehlersignale variiert ein kontinuierlich abstimmbarer Taktoszillator (VCO) die Frequenz der von ihm abgegebenen Taktsignale. Mit diesen Taktsignalen ist ein bidirektionaler Binärzähler beaufschlagt, dessen Zählgeschwindigkeit durch die Frequenz dieser Taktsignale und dessen Zählrichtung durch die Richtung der genannten Abweichungen festgelegt ist. Am Ausgang dieses Binärzählers treten entsprechend der Zählerstände für die Einstellung des Verstärkers dienende Stellsignale auf. Diese Stellsignale variieren aufgrund der vom Betrag der Fehlersignale abhängigen Frequenz der Taktsignale sowohl hinsichtlich der Grösse als auch hinsichtlich der zeitlichen Folge.

Es ist nun Aufgabe der vorliegenden Erfindung, einen Weg zu zeigen, wie bei einer Schaltungsanordnung der eingangs genannten Art das dynamische Verhalten verbessert werden kann.

Gelöst wird die vorstehend aufgezeigte Aufgabe bei einer Schaltungsanordnung der eingangs genannten Art erfindungsgemäss dadurch, dass der Pegeldiskriminator zusätzlich den Betrag der Regelabweichung ermittelt und dass der Regler abhängig von diesem Betrag der Regelabweichung die Zeitabstände festlegt, in denen Stellsignale an den Regelverstärker abzugeben sind.

Die Erfindung bringt den Vorteil mit sich, dass die Regelgeschwindigkeit abhängig vom Betrag der Regelabweichung verändert werden kann. So ist es möglich, dass bei grossen Regelabweichungen zunächst mit einer hohen Regelgeschwindigkeit der von dem Regelverstärker abgegebene Pegel stufenweise verändert wird. Auf diese Weise wird ein schnelles Einlaufen des Regelverstärkers erreicht. Unterschreitet dagegen die Regelabweichung einen festgelegten Betrag, so kann die Regelgeschwindigkeit reduziert werden, um einen konstanten, von kurzzeitigen Störungen unabhängigen Pegel am Ausgang des Regelverstärkers zu erzielen.

Vorteilhafte Ausgestaltungen und Weiterbildungen der Erfindung sind Gegenstand der Unteransprüche, auf die hiermit verwiesen wird.

Im folgenden wird die Erfindung anhand von Zeichnungen beispielsweise näher beschrieben.

Fig. 1 zeigt in einem Blockschaltbild eine Regeleinrichtung, bei der die Erfindung angewandt ist,

Fig. 2 zeigt in einem Blockschaltbild ein Mittelungsfilter der in Fig. 1 dargestellten Regeleinrichtung,

Fig. 3 zeigt eine Schwellenwertstufe der in Fig. 1 dargestellten Regeleinrichtung.

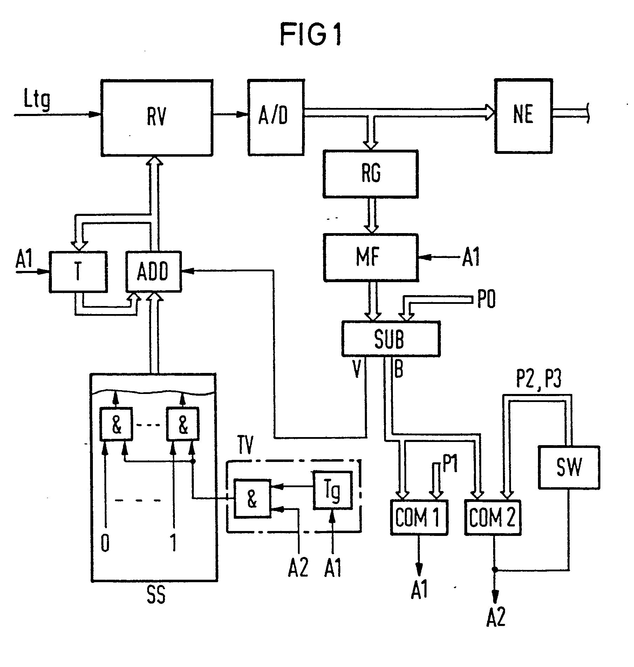

In Fig. 1 ist eine zu einem Nachrichtensignalempfänger gehörende Regeleinrichtung dargestellt. Diese Regeleinrichtung weist einen Regelverstärker RV auf, der mit einer Übertragungsleitung Ltg verbunden ist. Auf dieser Übertragungsleitung werden die Nachrichtensignale als analoge Signale, beispielsweise als Phasendifferenzsignale, übertragen. Unter Nachrichtensignale sollen hierbei beliebige Digitalsignale, wie z.B. Datensignale, Sprachsignale in codierter Form und/oder Textinformationssignale, verstanden werden.

Bei dem Regelverstärker RV handelt es sich um einen analogen Verstärker, dessen Verstärkung durch digitale Signale einstellbar ist. Die Kennlinie des Verstärkers ist logarithmisch. Damit verändert sich die Verstärkung in dB linear mit der digitalen Einstellung. Ausgangsseitig ist dieser Regelverstärker mit einem Analog/Digital-Wandler A/D verbunden. Dieser Analog/Digital-Wandler tastet die auf der Übertragungsleitung Ltg auftretenden und in dem Regelverstärker RV verstärkten Nachrichtensignale ab und gibt an seinem Ausgang den Abtastwerten entsprechende digitale Signale ab. Jedes dieser digitalen Signale besteht dabei aus einer Mehrzahl von Bits, die in paralleler Form abgegeben werden. Der Analog/Digital-Wandler ist hierzu mit den ihm nachfolgenden Einrichtungen über eine Leitungsanordnung verbunden, die aus einer der Anzahl der Bits entsprechenden Anzahl von Einzelleitungen besteht. Derartige, aus einer Mehrzahl von Einzelleitungen bestehende Leitungsanordnungen sind in Fig. 1 durch die breiten Verbindungslinien dargestellt.

Der Analog/Digital-Wandler A/D ist ausgangsseitig mit einem Nachrichtensignalempfänger NE verbunden, der die ihm zugeführten digitalen Signale aufnimmt und an mit ihm verbundene Endeinrichtungen abgibt. Auf den internen Aufbau dieses Nachrichtensignalempfängers und auf die Endeinrichtungen wird im folgenden jedoch nicht näher eingegangen. Der Analog/Digial-Wandler ist ausserdem mit einer Einrichtung für die Ermittlung einer Regelgrösse RG verbunden. Im einfachsten Fall besteht diese Regelgrösse aus dem Betrag des gerade von dem Analog/Digital-Wandler ermittelten Abtastwertes. Es können jedoch auch zwei unmittelbar benachbarte Abtastwerte bei der Ermittlung der Regelgrösse berücksichtigt werden. Dies kann in der Weise erfolgen, dass die Summe der Beträge der zwei aufeinanderfolgenden Abtastwerte oder die Summe der Quadrate der beiden Abtastwerte gebildet wird.

Die gerade erwähnte Regelgrösse wird anschliessend für eine Mitteilung einem Mittelungsfilter MF zugeführt. Auf dieses Mittelungsfilter wird im folgenden noch näher eingegangen werden. Vorab sei hier lediglich erwähnt, dass es sich hierbei um einen rekursiven Tiefpass erster Ordnung handelt, dessen die Zeitkonstante bestimmende Filterparameter durch Steuersignale änderbar sind. Nach der Mittelung der Regelgrösse erfolgt die Ermittlung der Regelabweichung. Hierfür ist dem Mittelungsfilter MF ein Subtrahierer SUB nachgeschaltet, der die Differenz zwischen der gemittelten Regelgrösse und einem dem Sollpegel am Ausgang des Regelverstärkers RV entsprechenden digitalen Wert bildet. Der dem Sollpegel entsprechende digitale Wert ist in Fig. 1 mit PO bezeichnet. Der Subtrahierer SUB gibt an seinen mit B bezeichneten Ausgängen den Betrag der Regelabweichung und an seinem mit V bezeichneten Ausgang die Richtung der Regelabweichung ab.

Der Betrag der Regelabweichung entscheidet darüber, welche die Zeitkonstante des Mittelungsfilters MF bestimmende Filterparameter für eine Mittelung der Regelgrösse zu verwenden sind. Hierfür wird der Betrag der Regelabweichung in einem mit den Ausgängen B des Subtrahierers SUB verbundenen Vergleicher COM1 mit einem Schwellwert P1 verglichen. Ergibt der Vergleicher, dass der Betrag der Regelabweichung über dem Schwellwert liegt, so wird für das Mittelungsfilter MF ein erster, eine kleine Zeitkonstante bewirkender Filterparametersatz verwendet. Liegt dagegen der Betrag der Regelabweichung unterhalb des Schwellwertes, so wird für die Mittelung ein zweiter, eine grosse Zeitkonstante bewirkender Filterparametersatz benutzt. Das für die Auswahl dieser Filterparametersätze von dem Vergleicher COM1 abgegebene Vergleichssignal ist in Fig. 1 mit A1 bezeichnet.

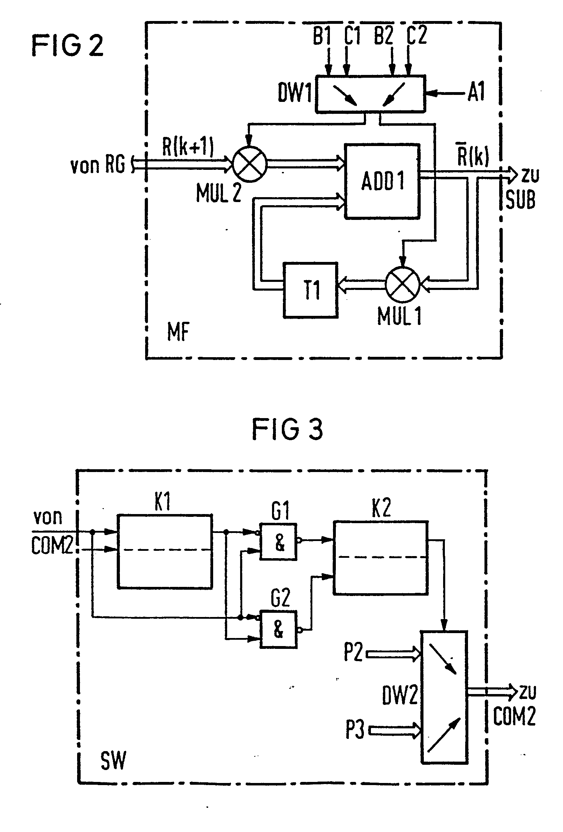

Der Subtrahierer SUB ist mit seinen Ausgängen B mit einem weiteren Vergleicher COM2 verbunden. Dieser Vergleicher vergleicht den Betrag der Regelabweichung wiederum mit einem Schwellwert. Dieser Schwellwert ist jedoch, im Gegensatz zum Schwellwert P1 des Vergleichers COM1, nicht fest vorgegeben, sondern er kann zwei unterschiedliche Werte annehmen. Der Betrag der Regelabweichung wird zunächst mit einem ersten Schwellwert P2 verglichen. Unterschreitet die Regelabweichung diesen Schwellwert, so wird für die nachfolgenden Vergleichsvorgänge ein zweiter, gegenüber dem ersten Schwellwert grösserer Schwellwert P3 benutzt. Wird dieser Schwellwert im Verlauf der Regelung von dem Betrag der Regelabweichung überschritten, so wird wieder auf den ersten Schwellwert P2 umgeschaltet. Für die gerade erläuterte Umschaltung der beiden Schwellwerte wird das von dem Vergleicher COM2 abgegebene Vergleichssignal, das in Fig. 1 mit A2 bezeichnet ist, einer Schwellwertstufe SW zugeführt. Diese Schwellwertstufe, deren Aufbau in Fig. 3 dargestellt ist, ermittelt bei einer Änderung des von dem Vergleicher COM2 abgegebenen Vergleichssignals A2 den für den weiteren Vergleich zu benutzenden Schwellwert und führt diesen dem Vergleicher COM2 zu. Auf die Verwendung des von dem Vergleicher COM2 abgegebenen Vergleichssignals A2 für die Einstellung der Verstärkung des Regelverstärkers RV wird im folgenden noch näher eingegangen werden.

Der bereits erwähnte Regelverstärker RV erhält von einer als Akkumulator zu bezeichnenden Einrichtung die für die Einstellung seiner Verstärkung erforderlichen digitalen Signale zugeführt. Dieser Akkumulator besteht aus einem Addierwerk ADD und einer Verzögerungseinrichtung T, die jeweils ein zu einem bestimmten Zeitpunkt von dem Addierwerk abgegebenes Summensignal dem Addierwerk für eine gegebenenfalls erforderliche Änderung in einem durch den Betrag der gerade vorhandenen Regelabweichung festgelegten Zeitabstand wieder zuführt. Bei einer solchen Änderung wird das dem Addierwerk wieder zugeführte Summensignal um einen festen Wert geändert, und zwar abhängig von der Richtung der Regelabweichung in der einen oder anderen Richtung. Die Richtung der Regelabweichung, die am Ausgang V des Substrahierers SÜB angezeigt wird, wird dem Addierwerk ADD hierfür als Steuersignal zugeführt.

Der Zeitabstand, in dem ein von dem Addierwerk ADD abgegebenes Summensignal geändert werden kann, ist durch die von der Verzögerungseinrichtung T verursachte Verzögerung festgelegt. Die Verzögerungszeit ist durch das von dem Vergleicher COM1 abgegebene Vergleichssignal A1 einstellbar, und zwar in der Weise, dass bei einem ein Überschreiten des Sollwertes P1 durch den Betrag der Regelabweichung anzeigenden Vergleichssignal die Verzögerungseinrichtung eine geringe Verzögerung verursacht. Wird dagegen durch das Vergleichssignal ein Unterschreiten des Sollwertes durch den Betrag der Regelabweichung angezeigt, so wird eine grössere Verzögerungszeit in der Verzögerungseinrichtung T eingestellt. Da durch die Verzögerungszeit der Verzögerungseinrichtung die Regelgeschwindigkeit der in Fig. 1 dargestellten Regeleinrichtung festgelegt ist, wird durch die gerade erläuterte Änderung der Verzögerungszeit auch eine entsprechende Änderung der Regelgeschwindigkeit erreicht.

Vorstehend wurde bereits darauf hingewiesen, dass ein von dem Addierwerk ADD abgegebenes Summensignal in einem festgelegten Zeitabstand um einen festen Wert geändert werden kann. Für diese Änderung ist das Addierwerk eingangsseitig mit einer Schalterstufe SS verbunden, die in dem festgelegten Zeitabstand den zu dem Summensignal zu addierenden bzw. zu subtrahierenden Wert bereitstellt. Diese Schalterstufe besteht aus einer Mehrzahl von UND-Gliedern, die an ihren Eingängen eine dem zu addierenden bzw. zu subtrahierenden Wert entsprechende Bitkombination zugeführt erhalten. Bei dem hier vorliegenden Ausführungsbeispiel ist diese Bitkombination so gewählt, dass lediglich das niederwertigste Bit des dem Addierwerk gerade zugeführten Summensignals geändert wird. In Fig. 1 ist dies dadurch angedeutet, dass lediglich das das niederwertigste Bit führende UND-Glied einen logischen Pegel «1» zugeführt erhält.

An jeweils einem weiteren Eingang werden den UND-Gliedern der Schalterstufe SS Taktsignale von einer Taktversorgungseinrichtung TV her zugeführt. Diese Taktsignale steuern die UND-Glieder in deren Übertragungszustand, in dem die an den übrigen Eingängen anliegende Bitkombination an das Addierwerk ADD abgegeben wird. Die zeitliche Folge der Taktimpulse entspricht dabei der von der Verzögerungseinrichtung T verursachten Verzögerungszeit, so dass die UND-Glieder nur dann in den Übertragungszustand überführt werden, wenn dem Addierwerk das von ihm gerade abgegebene Summensignal wieder zugeführt wird.

Die Taktversorgungseinrichtung TV weist einen Taktgenerator Tg auf, der wie die Verzögerungseinrichtung T mit dem Ausgang des Vergleichers COM1 verbunden ist. Damit steuert das von diesem Vergleicher abgegebene Vergleichssignal auch die Folgefrequenz der von dem Taktgenerator abgegebenen Taktimpulse. Der Taktgenerator gibt die Taktimpulse an einen Eingang eines ebenfalls zu der Taktversorgungseinrichtung TV gehörenden UND-Gliedes ab. An einem weiteren Eingang dieses UND-Gliedes ist der Ausgang des Vergleichers COM2 angeschlossen. Das von diesem Vergleicher abgegebene Vergleichssignal A2 steuert das UND-Glied nur dann in den übertragungsfähigen Zustand, indem es die Taktsignale an die Schalterstufe SS weiterleitet, wenn der Betrag der Regelabweichung den festgelegten Schwellwert P3 übersteigt. Dieser übertragungsfähige Zustand bleibt dann so lange erhalten, bis der Betrag der Regelabweichung den Schwellwert P2 unterschreitet. Im Sperrzustand des UND-Gliedes werden keine Taktimpulse an die Schalterstufe SS abgegeben. Diese verbleibt damit ebenfalls in ihrem Sperrzustand. In diesem Zustand geben die zu dieser Schalterstufe gehörenden UND-Glieder an ihren Ausgängen jeweils einen logischen Pegel «0» ab, so dass das dem Addierwerk zugeführte Summensignal unverändert bestehen bleibt.

In Fig. 2 ist ein möglicher Aufbau des bereits erwähnten Mittelungsfilters MF schematisch dargestellt. Dieses als rekursiver Tiefpass ausgebildete Mittelungsfilter weist einen Addierer ADD1 auf, der an seinem Ausgang die zu einem Zeitpunkt $T_A=kT$ gemittelte Regelgrösse $\bar{R}$ (k) abgibt, wobei der Zeitpunkt einem der Abtastzeitpunkte $T_A=kT$ mit k=0, ..., n des Analog/Digital-Wandlers A/D entspricht. Diese gemittelte Regelgrösse wird einerseits dem bereits erwähnten Subtrahierer SUB und andererseits einem ersten Multiplizierer MUL1 zugeführt, der die gemittelte Regelgrösse $\bar{R}$ (k) mit einem der von einer Datenweiche DW1 wahlweise abgegebenen Filterparameter C1 oder C2 multipliziert. Für die Auswahl des für die Mittelung gerade zu verwendenden Filterparameters ist ein Steuereingang der Datenweiche DW1 mit dem Ausgang des in Fig. 1 dargestellten Vergleichers COM1 verbunden.

Dem Multiplizierer MUL1 ist ein Verzögerungsglied T1 nachgeschaltet, welches das von dem Multiplizierer abgegebene Ausgangssignal um eine einem Abtastintervall des Analog/Digital-Wandlers A/D entsprechende Zeitspanne verzögert an erste Eingänge des Addierers ADD1 weiterleitet. Das durch das Verzögerungsglied T1 verzögerte Signal tritt damit zum Zeitpunkt $T_A=(k+1)T$ an den genannten Eingängen auf. Zu diesem Zeitpunkt wird von der Einrichtung für die Ermittlung einer Regelgrösse RG eine weitere Regelgrösse R(k+1) bereitgestellt. Diese Regelgrösse wird einem Multiplizierer MUL2 zugeführt, der diese mit einem der von der Datenweiche DW1 ebenfalls bereitgestellten Filterparameter B1 oder B2 multipliziert. Der dabei zu benutzende Filterparameter ist wieder durch das von dem Vergleicher COM1 abgegebene Vergleichssignal festgelegt. Das Ausgangssignal des Multiplizierers MUL2 wird anschliessend weiteren Eingängen des bereits erwähnten Addierers ADD1 zugeführt, der dieses zum Zeitpunkt $T_A=(k+1)T$ auftretende Ausgangssignal zu dem von dem Verzögerungsglied T1 ebenfalls zu diesem Zeitpunkt abgegebenen Signal addiert und nunmehr an seinem Ausgang als Summensignal eine gemittelte Regelgrösse $\bar{R}$ (k+1) abgibt.

In Fig. 3 ist ein möglicher Aufbau der in Fig. 1 dargestellten Schwellwertstufe SW wiedergegeben. Diese Schwellwertstufe weist eine erste Kippstufe K1 auf, die mit ihrem Dateneingang an dem Ausgang des Vergleichers COM2 angeschlossen ist. An ihrem Takteingang erhält diese Kippstufe Taktimpulse zugeführt, die beispielsweise zu den Abtastzeitpunkten $T_A=kT$ von dem Analog/Digital-Wandler A/D abgegeben werden. Ausgangsseitig ist diese Kippstufe mit einem invertierenden Eingang eines ersten NAND-Gliedes G1 verbunden, dessen nichtinvertierender Eingang an den Ausgang des Vergleichers COM2 angeschlossen ist. Die Kippstufe K1 ist ausserdem mit einem nichtinvertierenden Eingang eines zweiten NAND-Gliedes G2 verbunden, das an einem invertierenden Eingang das von dem Vergleicher COM2 abgebene Vergleichssignal zugeführt erhält.

Ausgangsseitig sind die beiden NAND-Glieder G1 und G2 mit einem Setz- bzw. Rücksetzeingang einer zustandsgesteuerten Kippstufe K2 verbunden. Der Ausgang dieser Kippstufe ist an einen Steuereingang einer Datenweiche DW2 angeschlossen. An ihren ersten bzw. zweiten Eingängen erhält diese Datenweiche den Schwellwert P2 bzw. P3 zugeführt. Ausgangsseitig ist die Datenweiche DW2 mit Eingängen des in Fig. 1 dargestellten Vergleichers COM2 verbunden.

Mit der gerade erläuterten Schwellwertstufe SW wird eine Änderung des von dem Vergleicher COM2 zu einem bestimmten Zeitpunkt $T_A=kT$ abgegebenen Vergleichssignals gegenüber einem zum Zeitpunkt $T_A=(k-1)T$ abgegebenen, in der Kippstufe K1 gespeicherten Vergleichssignal erkannt. Bei einer solchen Änderung tritt abhängig von deren Richtung lediglich am Ausgang eines der genannten NAND-Glieder G1 und G2 ein logischer Pegel «0» auf. Je nachdem, von welchem der NAND-Glieder dieser logische Pegel abgegeben wird, wird die Kippstufe K2 in ihren Setz- bzw. Rücksetzzustand überführt, in dem sie einen entsprechenden logischen Pegel an ihrem Ausgang abgibt. Der Ausgangspegel dieser Kippstufe legt dann den Schwellwert fest, der von der Datenweiche DW2 her dem Vergleicher COM2 für einen Vergleich zur Verfügung gestellt wird. Wie bereits oben erwähnt, ist die Auswahl des jeweiligen Schwellwertes abhängig von der Änderung des von dem Subtrahierer SUB zur Verfügung gestellten Betrages der Regelabweichung. So wird beim Unterschreiten des Schwellwertes P2 durch den von dem Subtrahierer SUB abgebenen Betrag der Regelabweichung für nachfolgende Vergleichsvorgänge der grössere Schwellwert P3 verwendet. Wird dieser Schwellwert P3 durch den Betrag der Regelabweichung dann überschritten, so wird wieder der niedrigere Schwellwert P2 dem Vergleicher COM2 für einen Vergleich zur Verfügung gestellt. Durch diese wechselweise Verwendung der beiden Schwellwerte P2 und P3 und durch das Konstanthalten der Verstärkung des oben genannten Regelverstärkers RV beim Unterschreiten des Schwellwertes P2 durch den Betrag der Regelabweichung wird die in Fig. 1 dargestellte Regeleinrichtung unempfindlich gegenüber kurzzeitigen Störungen und geringen Pegelschwankungen.

Bezüglich des Aufbaues des Subtrahierers SUB und des Addierwerkes ADD sei darauf hingewiesen, dass diese jeweils aus einem wahlweise die Summe oder die Differenz der jeweils zugeführten Eingangssignale ermittelnden Addierwerk gebildet sein können, wie es aus «Binäre Schaltkreise», Walter Wolfgarten, Dr. Alfred Hüthig Verlag Heidelberg, 1972, Seiten 147 bis 149 bekannt ist.

Abschliessend sei hier noch angemerkt, dass anstelle des oben genannten Addierwerkes ADD und der Verzögerungseinrichtung T auch ein Vor-/Rückwärts-Zähler verwendet werden kann, welcher von der Taktversorgungseinrichtung TV her Taktsignale zugeführt erhält und dessen Zählrichtung durch das von dem Subtrahierer SUB an seinem Ausgang V abgegebene, die Richtung der Regelabweichung anzeigende Signal festgelegt ist.

## Patentansprüche

1. Schaltungsanordnung für eine digitale Pegelregelung mit einem in seiner Verstärkung einstellbaren Regelverstärker (RV), der von einem Regler (ADD, T, SS, TV) her für eine stufenweise Veränderung seines Ausgangspegels in vorgegebenen Zeitabständen Stellsignale zugeführt erhält, und mit einem Pegeldiskriminator (SUB), der bei einer Abweichung des von dem Regelverstärker als Regelgrösse abgegebenen Pegels von einem Sollpegel ein die Richtung der Regelabweichung anzeigendes Signal als Stellgrösse an den Regler abgibt, dadurch gekennzeichnet, dass der Pegeldiskriminator (SUB) zusätzlich den Betrag der Regelabweichung ermittelt und dass der Regler (ADD, T, SS, TV) abhängig von diesem Betrag der Regelabweichung die Zeitabstände festlegt, in denen Stellsignale an den Regelverstärker abzugeben sind.

2. Schaltungsanordnung nach Anspruch 1, dadurch gekennzeichnet, dass dem Pegeldiskriminator (SUB) eine der Mittelung der von dem Regelverstärker abgegebenen Regelgrösse dienende Einrichtung (MF) vorgeschaltet ist, deren Zeitkonstante abhängig vom Betrag der Regelabweichung variierbar ist.

3. Schaltungsanordnung nach Anspruch 2, dadurch gekennzeichnet, dass die der Mittelung der Regelgrösse dienende Einrichtung (MT) ein Mittelungsfilter in Form eines rekursiven Tiefpasses aufweist, dessen Filterparameter abhängig vom Betrag der Regelabweichung änderbar sind.

4. Schaltungsanordnung nach einem der Ansprüche 1 bis 3, dadurch gekennzeichnet, dass der Regler (ADD, T, SS, TV) einen Akkumulator (ADD, T) aufweist, welcher an seinem Ausgang als Stellsignal für den Regelverstärker (RV) ein Summensignal abgibt, welches bei einer Regelabweichung in durch den Betrag der Regelabweichung festgelegten Zeitabständen abhängig von dem jeweils von dem Pegeldiskriminator (SUB) abgegebenen, die Richtung der Regelabweichung anzeigenden Signal um einen festgelegten Wert verändert wird.

5. Schaltungsanordnung nach Anspruch 4, dadurch gekennzeichnet, dass der Akkumulator aus einem Addierwerk (ADD) und einer Verzögerungseinrichtung (T) besteht, die jeweils das zu einem bestimmten Zeitpunkt von dem Addierwerk abgegebene Summensignal nach einem durch den Betrag der gerade vorhandenen Regelabweichung festgelegten Zeitabstand dem Addierwerk für eine gegebenenfalls erforderliche Änderung wieder zuführt.

6. Schaltungsanordnung nach Anspruch 4, dadurch gekennzeichnet, dass der Akkumulator einen Vor-/Rückwärts-Zähler aufweist, welcher von einem Taktgenerator her in durch den Betrag der Regelabweichung festgelegten Zeitabständen Taktsignale zugeführt erhält und dessen Zählrichtung durch die Richtung der Regelabweichung festgelegt ist.

7. Schaltungsanordnung nach einem der Ansprüche 4 bis 6, dadurch gekennzeichnet, dass der Akkumulator nur dann ein von ihm abgegebenes Summensignal korrigiert, wenn der Betrag der Regelabweichung einen festgelegten ersten Wert überschreitet und dass der Akkumulator nur so lange ein Summensignal korrigiert, bis der Betrag der Regelabweichung einen festgelegten, gegenüber dem ersten Wert niedrigeren zweiten Wert unterschreitet.

**Claims**

1. Circuit arrangement for a digital level control having a control amplifier (RV), of adjustable amplification, which is actuating signals at predetermined intervals from a controller (ADD, T, SS, TV) in order to vary its output level in steps, and having a level discriminator (SUB), which, when the level transmitted as controlled variable by the control amplifier deviates from a set level, transmits to the controller as manipulated variable a signal indicating the direction of the control deviation, characterized in that the level discriminator (SUB) additionally determines the amount of the control deviation, and in that the controller (ADD, T, SS, TV) specifies, as a function of this amount of the control deviation, the intervals at which actuating signals are to be transmitted to the control amplifier.

2. Circuit arrangement according to Claim 1, characterized in that there is connected upstream of the level discriminator (SUB) a decive (MF) serving to average the controlled variable transmitted by the control amplifier, the time constant of which device can be varied as a function of the amount of the control deviation.

3. Circuit arrangement according to Claim 2, characterized in that the device (MT) serving to average the controlled variable has an averaging filter in the form of a recursive low pass filter, the filter parameters of which can be altered as a function of the amount of the control deviation.

4. Circuit arrangement according to one of the Claims 1 to 3, characterized in that the controller (ADD, T, SS, TV) has an accumulator (ADD, T), which transmits at its output as actuating signal for the control amplifier (RV) an aggregate signal which, given a control deviation, is changed by a specified value at intervals as specified by the amount of the control deviation, as a function of the particular signal transmitted by the level discriminator (SUB) and indicating the direction of the control deviation.

5. Circuit arrangement according to Claim 4, characterized in that the accumulator consists of an adder (ADD) and a delay device (T), which device, after an interval specified by the amount of the currently occurring control deviation, in each case once again feeds to the adder the aggregate signal transmitted by the adder at a definite instance for the purpose of any necessary alteration.

6. Circuit arrangement according to Claim 4, characterized in that the accumulator has an up/down counter, which is fed clock pulses by a clock-pulse generator at intervals specified by the amount of the control deviation, and whose counting direction is specified by the direction of the control deviation.

7. Circuit arrangement according to one of Claims 4 to 6, characterized in that the accumulator corrects an aggregate signal which it has transmitted only if the amount of the control deviation overshoots a specified first value, and in that the accumulator corrects an aggregate signal only for as long as the amount of the control deviation undershoots a specified second value, which is lower in relation to the first value.

**Revendications**

1. Montage pour une régulation numérique de niveau, comprenant un amplificateur de réglage (RV) dont le gain est ajustable et qui reçoit à intervalles de temps préfixés des signaux d'ajustement d'un régulateur (ADD, T, SS, TV) en vue d'une variation par paliers de son niveau de sortie, ainsi qu'un discriminateur de niveaux (SUB) qui, en cas d'écart du niveau délivré en tant que grandeur réglée par l'amplificateur de réglage, par rapport à un niveau de consigne, délivre au régulateur un signal indiquant le sens de l'écart de réglage en tant que variable réglante, caractérisé en ce que le discriminateur de niveaux (SUB) détermine, en plus, la valeur de l'écart de réglage et que le régulateur (ADD, T, SS, TV) fixe, en fonction de cette valeur de l'écart de réglage, les intervalles de temps dans lesquels des signaux d'ajustement sont à délivrer à l'amplificateur de réglage.

2. Montage selon la revendication 1, caractérisé en ce que le discriminateur de niveaux (SUB) est précédé d'un dispositif (MF) servant à la formation de la moyenne de la grandeur réglée délivrée par l'amplificateur de réglage, dispositif dont la constante de temps est variable en fonction de la valeur de l'écart de réglage.

3. Montage selon la revendication 2, caractérisé en ce que le dispositif (MT) servant à la formation de la moyenne de la grandeur réglée, présente un filtre formateur de moyenne sous forme d'un passe-bas récursif dont les paramètres de filtrage peuvent être changés en fonction de la valeur de l'écart de réglage.

4. Montage selon une des revendications 1 à 3, caractérisé en ce que le régulateur (ADD, T, SS, TV) présente un accumulateur (ADD, T) qui délivre à sa sortie un signal somme en tant que signal d'ajustement pour l'amplificateur de réglage (RV), signal qui est changé, en cas d'écart de réglage, dans des intervalles de temps fixés par la valeur de l'écart de réglage, en fonction du signal délivré par le discriminateur de niveaux (SUB) et indiquant le sens de l'écart de réglage, le changement portant chaque fois sur une valeur fixe.

5. Montage selon la revendication 4, caractérisé en ce que l'accumulateur est composé d'un additionneur (ADD) et d'un dispositif de temporisation (T) qui renvoie à l'additionneur, en vue d'un changement éventuellement nécessaire, après un intervalle de temps fixé par la valeur de l'écart de réglage existant à ce moment, le signal somme délivré à un moment déterminé par l'additionneur.

6. Montage selon la revendication 4, caractérisé en ce que l'accumulateur présente un compteur/décompteur qui reçoit des signaux de rythme d'un générateur de rythme dans des intervalles de temps fixés par la valeur de l'écart de réglage et dont le sens du comptage est fixé par le sens de l'écart de réglage.

7. Montage selon une des revendications 4 à 6, caractérisé en ce que l'accumulateur corrige seulement un signal somme délivré par lui lorsque la valeur de l'écart de réglage dépasse une première valeur fixe et que l'accumulateur corrige seulement un signal somme jusqu'à ce que la valeur de l'écart de réglage descende au-dessous d'une seconde valeur fixe, inférieure à la première.

# FIG 1

# FIG 2

# FIG 3